# EUROPEAN PATENT SPECIFICATION

(11) **EP 3 046 155 B1**
(45) Date of publication and mention of the grant of the patent: **20.11.2019**
(21) Application number: 16151111.8
(22) Date of filing: 13.01.2016
(51) Int. Cl.: H01L 45/00

(54) **CONDUCTIVE BRIDGING MEMORY DEVICE WITH CATION SUPPLY ELECTRODE COMPRISING CU-SI-TE**
LEITFÄHIGE ÜBERBRÜCKUNGSSPEICHERVORRICHTUNG MIT KATIONEN BEREITSTELLENDER ELEKTRODE ENTHALTEND CU-SI-TE
DISPOSITIF DE MÉMOIRE PAR LIAISON CONDUCTRICE AYANT UNE ÉLECTRODE À SOURCE DE CATIONS COMPRENANT CU-SI-TE

(30) Priority: 15.01.2015 EP 15151265
(43) Date of publication of application: 20.07.2016
(73) Proprietor: IMEC VZW, 3001 Leuven (BE); Universiteit Gent, 9000 Gent (BE)
(72) Inventor: DEVULDER, Wouter, 3001 Leuven (BE); GOUX, Ludovic, 3001 Leuven (BE); OPSOMER, Karl, 3001 Leuven (BE)
(74) Representative: Patent Department IMEC

(56) References cited:
- EP-B1- 2 161 750
- US-A1- 2013 175 494
- US-B1- 8 598 560
- US-B2- 6 985 378
- US-B2- 7 696 511
- US-B2- 8 699 260

## Description

### Field

The present disclosure relates to Conductive Bridging Random Access Memory devices, also known as CBRAM devices. In particular the present disclosure relates to a CBRAM device having a top electrode comprising Cu, Te and (Ge or Si).

### State of the art

The Conductive Bridging Random Access Memory (CBRAM) device is considered as a valuable non-volatile storage technology. It offers fast switching, high endurance, low voltage and good scalability.

A CBRAM device contains an insulating layer sandwiched between an active electrode providing metal cations, e.g. Cu⁺ or Ag⁺, and an inert electrode. The operation of the CBRAM device relies on the voltage-induced redox-based formation and rupture of a Cu- or Ag-based conical shaped conductive filament (CF) in the insulating layer acting as a solid state electrolyte. When an electrical field is applied between both electrodes, Cu- or Ag cations provided by the active electrode will drift towards the opposite inert electrode through the insulating layer thereby forming the conductive filament in the electrolyte. As a result, the CBRAM device can be reversibly switched between a high resistive (HRS) or reset state and a low resistive (LRS) or set state.

A challenge that CBRAM devices, in particular those having a Cu-containing active electrode, need to overcome is to improve their retention properties. Retention is the stability of respectively both the LRS and the HRS state and is determined as the lifetime of the device at an elevated temperature. A typical specification is a lifetime of 10 years at, depending on the application, a temperature of 50°C, 85°C or even up to 150°C.

One method to improve the retention of the LRS state only, i.e. the stability of the formed metallic CF, is to engineer an electrolyte element in which the Cu-CF will not dissolve. Examples of such electrolytes are oxides, such as GdO2 or Al2O3, resulting in a LRS retention of the CBRAM device higher than if chalcogenide electrolytes are used.

Another method to partly improve the retention of a CBRAM device is to engineer an appropriate active electrode supplying Cu-ions. CBRAM devices having a Cu active electrode exhibit a poor HRS retention. By adding Te to the Cu active electrode, the HRS stability is increased, however at the expense of a reduced LRS stability. This reduced stability effect was attributed to the chemical affinity between Cu and Te, which favors the Cu back-diffusion from the CF towards the Cu-Te supply element. By incorporating Ge into the Cu-Te containing active electrode, a trade-off can be made between the thermal stability of the LRS and the HRS states. US 8 598 560 B1 discloses CBRAM devices with cation supply electrodes of Cu-Te alloys comprising Ge or Si, on a zirconium oxide resistance switching electrolyte layer. Concrete embodiments contain 60% Cu, 20% Ge, 20% Te (example 7), and 38.5% Cu, 30% Si, 31.5% Te (example 6, fourth sample), respectively, all values denoting atomic %. Similar devices having CuGeTe ion source electrodes are known from US 2013/175494 A1. EP 2 161 750 B1 and US 7 696 511 B2 teach other similar CBRAMs with Cu(Ge,Si)Te ion source electrodes further comprising small amounts of Gd or Zr, on electrolyte layers of gadolinium oxide or nitride.

These prior art devices however showed a decreased performance when subjected to elevated temperatures.

Hence, there is a need for a CBRAM device that doesn't suffer from shortcomings of the state-of-the-art CBRAM devices.

### Summary

A Conductive Bridge Random Access Memory (CBRAM) device is disclosed comprising an insulating electrolyte element sandwiched between a cation supply metal electrode and a bottom electrode, the cation supply metal electrode (3) comprises a CuₓSi_{y}Te_{z} alloy with a composition x= 48 at.%, y= 20 at. % and z= 32 at.%.

### Brief description of the figures

For the purpose of teaching, drawings are added. These drawings illustrate some aspects and embodiments of the disclosure. They are only schematic and non-limiting. The size of some of the elements may be exaggerated and not drawn on scale for illustrative purposes. The dimensions and the relative dimensions do not correspond to actual reductions to practice of the disclosure Like feature are given the same reference number.

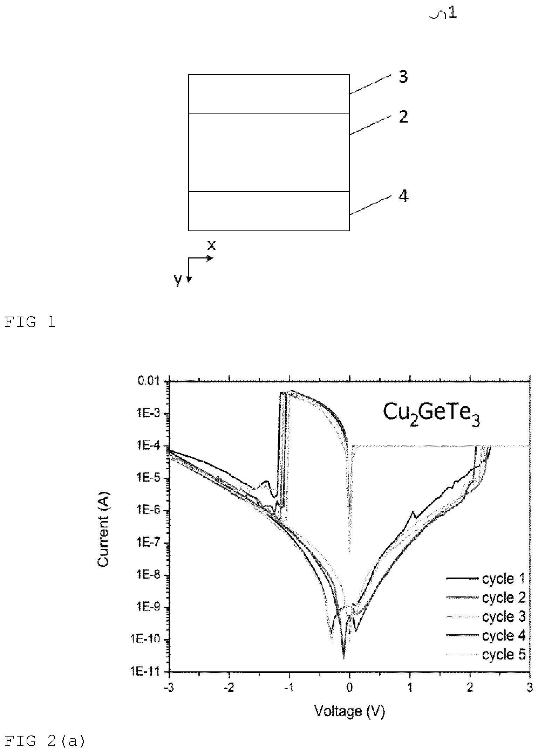

FIG 1 illustrates a CBRAM device according to this disclosure.
FIG 2(a) to 2(d) shows the electrical characterization of 580 pm diameter Pt/CuₓTe_{y}Ge_{z}/Al₂O₃/Si dot cells with a Cu₂GeTe₃ supply layer (active electrode) according to this disclosure: (a) I-V curves, (b) Low Resistance state (LRS: bottom, circles) and High Resistance state (HRS: top, squares) over 200 subsequent cycles, (c) LRS (bottom, squares I_{c} of 100µA, diamond I_{c} of <100pA) and HRS (top, circles I_{c} of 100µA) as function of time at 85°C, , and (d) the electrical resistance after 121.6h baking at 85°C as function of resistance after programming: LRS (bottom left, squares I_{c} of 100µA, diamond I_{c} of <100pA) and HRS (top right, circles I_{c} of 100µA).

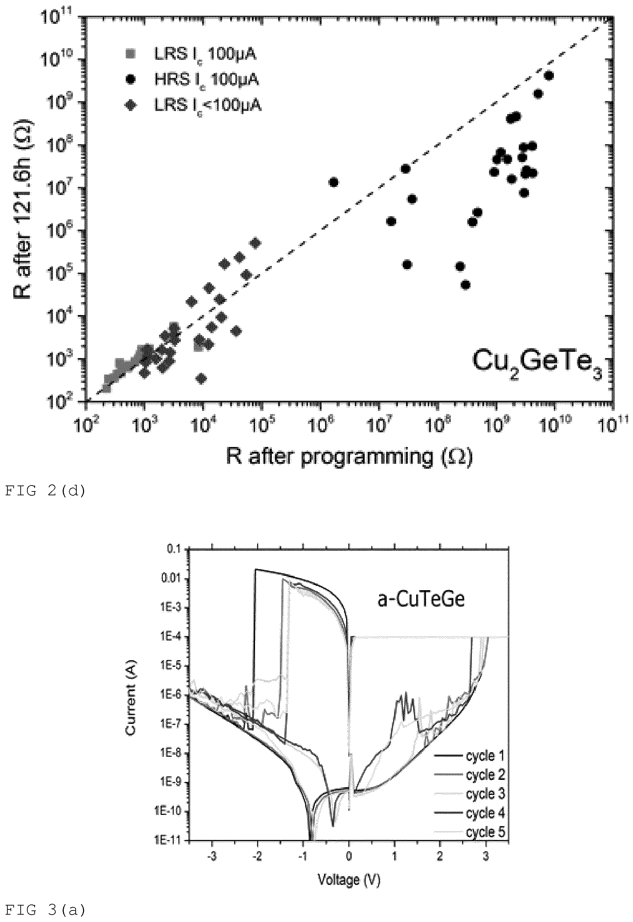

FIG 3(a) to 3(c) shows the electrical characterization of 580 µm diameter Pt/CuₓTe_{y}Ge_{z}/Al₂O₃Si dot cells with a Cu-Te-Ge supply layer (active electrode) with large amorphous window according to this disclosure: (a) I-V curves, (b) Low Resistance State (LRS: bottom, squares I_{c} of 100µA, diamond I_{c} of 10µA) and High Resistance State (HRS: top, circles I_{c} of 100µA) as function of time at 85°C, and (c) the electrical resistance after 121.6h baking at 85°C as function of resistance after programming: LRS (bottom left, squares I_{c} of 100µA, diamond I_{c} of <100pA) and HRS (top right, circles I_{c} of 100µA).

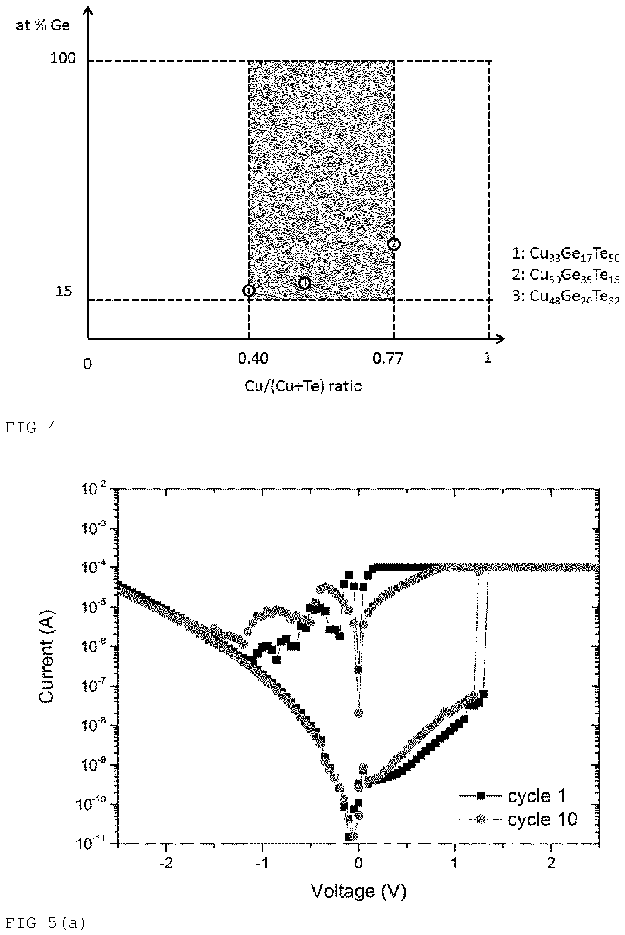

FIG 4 shows the amount of Ge (at. %) as function of the ratio Cu/(Cu+Te) in the cation metal supply electrode (3) according to this disclosure.
FIG 5(a) to 5(c) shows the electrical characterization of 580 pm diameter Pt/CuₓSi_{y}Ge_{z/}Al₂O₃/Si dot cells with a Cu-Te-Si supply layer (active electrode) with large amorphous window according to the present invention : (a) I-V curves, (b) Low Resistance State (LRS: bottom, squares I_{c} of 100µA, diamond I_{c} of 50µA) and High Resistance State (HRS: top, circles I_{c} of 100µA) as function of time at 85°C, and (c) the electrical resistance after 121.6h baking at 85°C as function of resistance after programming: LRS (bottom left, squares I_{c} of 100µA, diamond I_{c} of 50µA) and HRS (top right, circles I_{c} of 100µA).

### Detailed description

The present disclosure will be described with respect to particular embodiments and with reference to certain drawings but the disclosure is not limited thereto. Furthermore, the terms first, second and the like in the description, are used for distinguishing between similar elements and not necessarily for describing a sequence, either temporally, spatially, in ranking or in any other manner. It is to be understood that the terms so used are interchangeable under appropriate circumstances and that the embodiments of the disclosure described herein are capable of operation in other sequences than described or illustrated herein. Moreover, the terms top, under and the like in the description are used for descriptive purposes and not necessarily for describing relative positions. It is to be understood that the terms so used are interchangeable under appropriate circumstances and that the embodiments of the disclosure described herein are capable of operation in other orientations than described or illustrated herein.

The present disclosure relates to a CBRAM device (1) with improved thermal stability. The CBRAM device has an active electrode (3) containing Cu and Te, whereby this electrode (3) is further alloyed with Si or Ge.

In particular a CBRAM device is disclosed comprising an active electrode (3) comprising Cu, Ge and Te, whereby the active electrode (3) has an improved thermal stability.

The inventors have found that a deficiency of the state-of-the-art Cu-Ge-Te active electrodes is to have a microstructure of this (Cu,Ge,Te)-alloy, constituting the active electrode, being thermally unstable. At elevated temperatures these prior art Cu-Ge-Te alloys suffer, amongst other, from phase separation or undesired crystallization, more roughened surfaces which results in a reduced reproducibility and malfunctioning of the device. Due to this thermal instability, the further manufacturing of the CBRAM device once the active electrode is formed, is impacted, in particular the thermal budget that can be allowed during the Back-End-Of-Line (BEOL) processing when establishing an electrical interconnect to the CBRAM device. This instability jeopardizes the programming properties of the finished CBRAM device, while improving the retention of both the LRS and the HRS has become more difficult. A non-uniformity might be introduced between CBRAM devices due to this thermal instability. The affinity between the conductive filament and the active electrode (supply layer) may vary locally if the microstructure of the active electrode is not uniform due to different bonding configuration of Cu electrode with the alloying elements Te and Ge. Hence the HRS and LRS stability may be non-uniform from cell to cell.

Such CBRAM device is illustrated in FIG 1. Here a Conductive Bridge Random Access Memory (CBRAM) device (1) is shown comprising an insulating electrolyte element (2) sandwiched between a cation supply metal electrode (3) and a bottom electrode (4). The bottom electrode (4) is labelled 'inert' as it doesn't provide cations during the filament (11) forming process. The cation supply metal electrode (3), also referred to as active electrode (3), may comprise a (Cu, Ge, Te)-alloy that is thermally stable, and preferably consists of a homogeneous composition and structure, e.g. being amorphous or having a , preferably mono-, crystalline phase.

The cation supply electrode (3) may comprise Cu, Ge and Te, thereby supplying Cu⁺ cations during programming of the CBRAM device (1). The cation supply metal electrode (3) may comprise a CuₓGe_{y}Te_{z} alloy, with 0<x, y, z <100 at.%, whereby y>15 at.%.

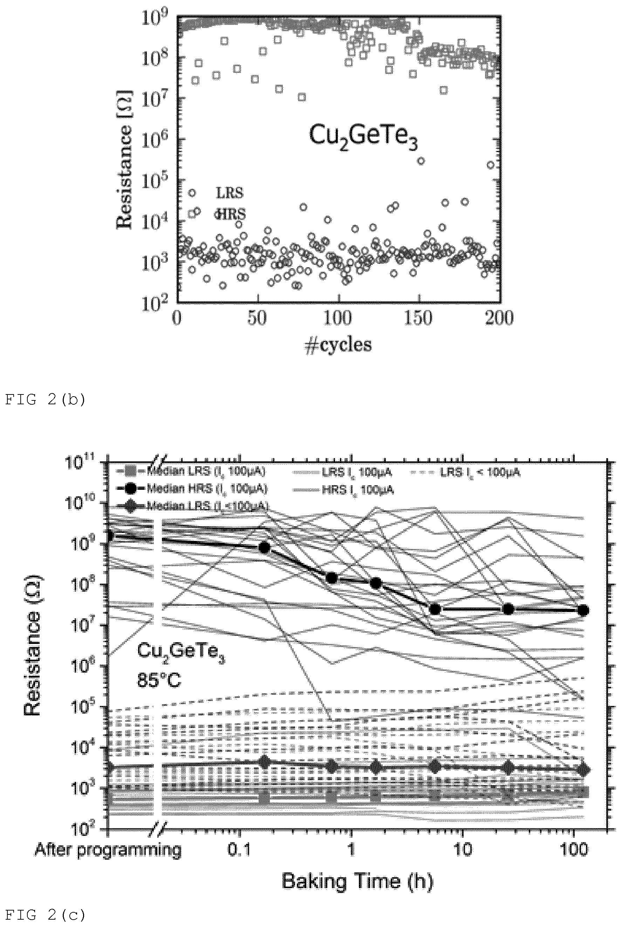

In a first embodiment, outside the scope of the claimed invention, the cation supply electrode (3) consists of a Cu₂Ge₁Te₃ alloy: Cu₃₃Ge₁₇Te₅₀. Initially formed as an amorphous layer, its composition favours a single type of chemical binding between Cu and the alloying elements Te and Ge. After crystallization, typically at a temperature of about 200°C, this Cu-Ge-Te alloy exhibits a single stable phase up to the typical temperatures applied during the BEOL processing, i.e. temperatures of about 450°C, preferably to about 450°C. Back-End-Of-Line (BEOL) processing refers the process steps establishing an electrical interconnect to the CBRAM device. These process steps include the formation of at least one metallic interconnect pattern separated by one or more dielectric layers, whereby openings in the dielectric layers allows electrically contacting the underlying CBRAM device and, if present, additional metallic interconnect patterns above. Alloys having another Cu-Ge-Te composition segregate into different crystal phases during such BEOL processing. Such segregations are not desired and may for example lead to non-uniform device properties. Retention properties were demonstrated for a CBRAM device having such Cu2GeTe3 alloy being at least comparable to prior art CBRAM devices having a Cu or Cu6Te4 cation supply electrode (3), but with an improved uniformity thanks to the homogenous alloy structure.
A 50nm Pt/ 50nm Cu-supply layer is deposited by sputter deposition through a 580pm dot shadow mask onto a 3nm Al₂O₃ layer, which in turn is deposited by an H₂O based ALD process on n-doped Si. FIG 2a to 2d show the electrical characterization of these 580 pm diameter Pt/CuₓTe_{y}Ge_{z}/Al₂O₃/Si dot cells with a Cu₂GeTe₃ supply layer (active electrode) according to this disclosure. FIG 2(a) shows the DC I-V curves. FIG 2(b) shows the Low Resistance state (LRS: open circles) and High Resistance state (HRS: open squares) over 200 subsequent cycles. The macroscopic cells show good endurance as it can be cycled at least 100 times. FIG 2(c) shows HRS as function of time at 85°C, programmed using I_{c} of 100µA and the LRS as function of time at 85°C, programmed using I_{c} of 100µA or less. The resistance of all measured memory cells is shown and their median value (solid symbols) after every anneal step at 85°C. The current in the set operation was limited (current compliance I_{c}) to 100µA to avoid overgrown filaments. FIG 2(d) shows the electrical resistance after 121.6h baking at 85°C as function of resistance after programming. As shown in FIG 2(d), cells were also programmed with I_{c}<100µA to get more cells in a LRS having higher resistance values (10k<R<100k), their resistance is also plotted. It can be seen that these cells also stay in their as programmed state. The mono phase Cu₂GeTe₃ composition showed an acceptable retention. It is observed that the HRS is still the weak state, while a very stable LRS is present (also for 10kΩ<R_{LRS}<100kΩ). However, a resistive window of ∼4 orders of magnitude of the median resistance values is still present after 121.6h baking at 85°C.

In a second embodiment, outside the scope of the claimed invention, the cation supply electrode (3) comprises a CuₓGe_{y}Te_{z} alloy whereby the composition is selected to yield an alloy that remains amorphous over a larger temperature window, in particular up to the temperatures selected for the BEOL processing, which processing temperatures are typically below 500°C, preferably below 400°C.

In an example of this second embodiment, the ratio (Cu/Te)>1. Such an alloy is referred to as a Te-poor (Cu,Ge,Te)-alloy. Preferably this alloy has a composition of Cu₅₀Ge₃₅Te₁₅. By reducing the amount of Te in the alloy, the crystallization temperature of the CuₓGe_{y}Te_{z} alloy is increased, preferably to about 300°C. If the temperatures applied during the BEOL processing is below this crystallisation temperature, i.e. below 300°C, the alloy will remain amorphous during the BEOL processing. This prevents phase separation as the forming of different crystal phases will take place at higher temperatures. a good retention was demonstrated also for this preferred composition.

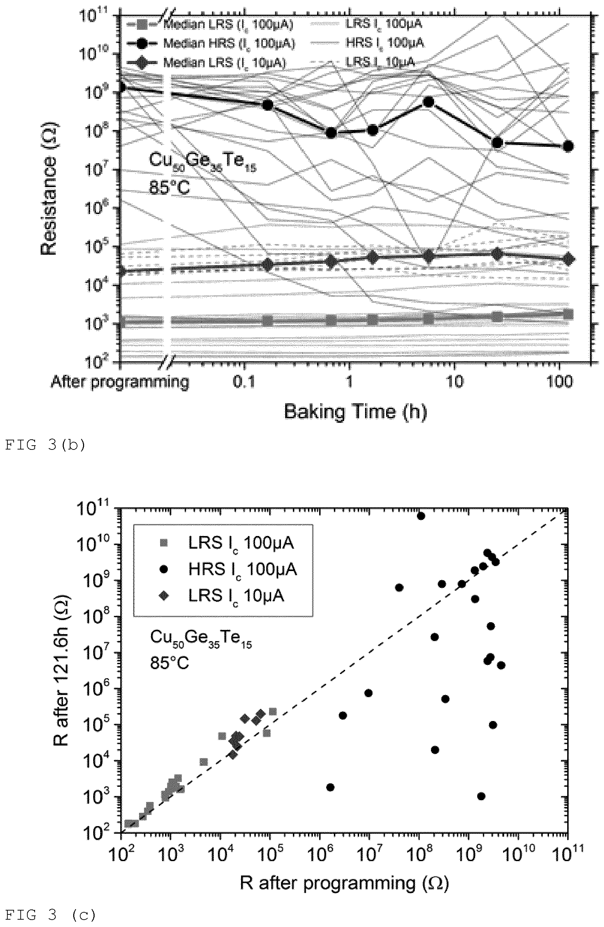

A 50nm Pt/ 50nm Cu-supply layer is deposited by sputter deposition through a 580pm dot shadow mask onto a 3nm Al₂O₃ layer, which in turn is deposited by an H₂O based ALD process on n-doped Si. FIG 3a to 3c show the electrical characterization of these 580 pm diameter Pt/CuₓTe_{y}Ge_{z}/Al₂O₃/Si dot cells with a Cu-Te-Ge supply layer (active electrode) with large amorphous window according to this disclosure. FIG 3(a) shows the I-V curves. FIG 3(b) shows High Resistance State (HRS) as function of time at 85°C, programmed using I_{c} of 100µA, and the LRS as function of time at 85°C, programmed using I_{c} of 100µA or 10 µA. The current in the set operation is limited (current compliance I_{c}) to 100µA to avoid overgrown filaments. The resistance of all measured memory cells is shown and their median value (solid symbols) after every anneal step at 85°C.FIG 3(c) shows the electrical resistance after 121.6h baking at 85°C as function of resistance after programming. As shown in FIG 3(c), cells were also programmed with 10µA to get more cells in a LRS having higher resistance values (10k<R<100k), their resistance is also plotted. It can be seen that these cells also stay in their as programmed state. The composition with the large amorphous temperature window is attractive form materials viewpoint and also showed an acceptable retention. It is observed that the HRS is still the weak state, while a very stable LRS is present (also for 10kΩ<R_{LRS}<100kΩ). However, a resistive window of ∼4 orders of magnitude of the median resistance values is still present after 121.6h baking at 85°C.

In another example of this second embodiment, the cation supply electrode (3) comprises a CuₓGe_{y}Te_{z} alloy, whereby the ratio (Cu/Te) ratio can be in the range of (50/35) to (50/40). Preferably this alloy has a composition Cu₄₈Ge₂₀Te₃₂. By increasing the amount of Te in the alloy, the crystallization temperature of the CuₓGe_{y}Te_{z} alloy is reduced, preferably to about 200°C. If the temperatures applied during the BEOL processing are below this crystallisation temperature, i.e. below 200°C, this alloy will remain again amorphous during the BEOL processing. This prevents phase separation because as the formation of different crystal phases will take place at higher temperatures.

FIG 4 shows the amount of Ge (at. %) as function of the ratio Cu/(Cu+Te) in the cation metal supply electrode (3). The grey area illustrates the CuₓGe_{y}Te_{z} alloys, with 0<x, y, z <100 at.%, whereby y>15 at.% according to this disclosures. Preferably the ratio Cu/(Cu+Te) is between 0.4 and 0.77 as shown by the grey area. The examples discussed in the foregoing paragraphs are indicated.

As discussed in the second embodiment, the CuTe cation supply electrode (3) is to be alloyed as to yield an alloy that remains amorphous over a larger temperature window, in particular up to the temperatures selected for the BEOL, which processing temperatures are typically below 500°C , preferably below 400°C.

The inventors had found that using Si as alloying element to the CuTe cation supply electrode (3), in a device as illustrated in FIG 1, results in a CuₓSi_{y}Te_{z} electrode (3) that remains amorphous over an even larger temperature window compared to a CuₓGe_{y}Te_{z} alloy

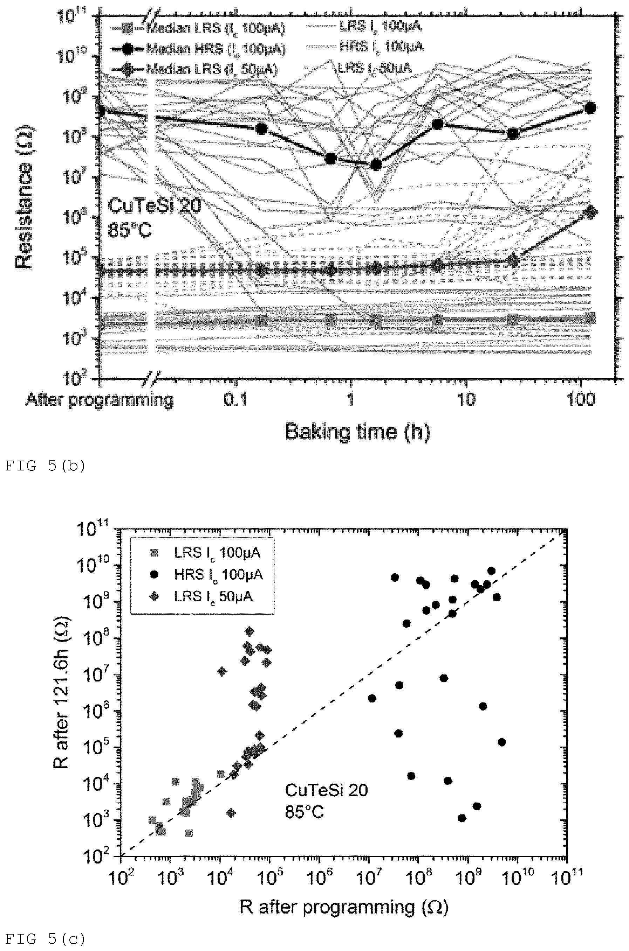

In an embodiment according to the present invention, such an amorphous electrode is obtained by using a CuₓSi_{y}Te_{z} alloy with a composition x= 48 at.%, y= 20 at.% and z= 32 at.%. Similar to the embodiments illustrated by FIG 2(a) to 2(d) and 3(a) to 3(c), FIG 5(a) to 5(c) shows the electrical characterization of 580 pm diameter Pt/CuₓSi_{y}Ge_{z}/Al₂O₃/Si dot cells with a Cu-Te-Si supply layer (active electrode) with large amorphous window according to the present invention. FIG 5(a) shows the I-V curves, i.e. the switching characteristics. FIG 5(b) shows the Low Resistance State (LRS: bottom, squares I_{c} of 100µA, diamond I_{c} of 50µA) and High Resistance State (HRS: top, circles I_{c} of 100µA) as function of time at 85°C. FIG 5(c) shows the electrical resistance after 121.6h baking at 85°C as function of resistance after programming: LRS (bottom left, squares I_{c} of 100µA, diamond I_{c} of 50µA) and HRS (top right, circles I_{c} of 100µA).

The dielectric material of insulating electrolyte element (2) is selected from the group of chalcogenides. This dielectric material can be selected from the group of mixed ionic-electronic conductors (MIEC), such as CeO, ZrO, Y203, Yttria Stabilized Zirconia (YSZ), characterised by their very high ionic conductivity. Preferably, this dielectric material is selected from the group of alumina oxides, hafnium oxides, tantalum oxides, silicon oxides of silicon nitrides.

Optionally a metallic liner (not shown) is formed, separating the cation supply electrode (3) from the electrolyte element (2). This metallic layer preferably contains Ta or TiW. This liner improves the adhesion between the Cu supply layer and the electrolyte. In addition it reduces Cu migration into the electrolyte during the BEOL processing.

Typically the bottom electrode (4) comprises tungsten. Preferably the bottom electrode (4) is formed of tungsten.

## Claims

1. A Conductive Bridge Random Access Memory device (1) comprising:
an insulating electrolyte element (2) sandwiched between a cation supply metal electrode (3) and a bottom electrode (4),
wherein the cation supply metal electrode (3) comprises a CuₓSi_{y}Te_{z} alloy,
**characterised in that** x= 48 at.%, y= 20 at.% and z= 32 at.%.

## Patentansprüche

1. Direktzugriffsspeichervorrichtung (1) mit leitfähiger Brücke, umfassend:
ein isolierendes Elektrolytelement (2), das zwischen einer Kationenzufuhrmetallelektrode (3) und einer Bodenelektrode (4) angeordnet ist,
wobei die Kationenzufuhrmetallelektrode (3) eine Cu_{X}Si_{Y}Te_{Z}-Legierung umfasst, **dadurch gekennzeichnet, dass** x= 48 At.-%, y= 20 At.-% und z= 32 At.-%.

## Revendications

1. Dispositif de mémoire vive à pont conducteur (1) comprenant :
un élément d'électrolyte isolant (2) intercalé entre une électrode métallique d'alimentation en cation (3) et une électrode inférieure (4),
dans lequel l'électrode métallique d'alimentation en cation (3) comprend un alliage de CuₓSi_{y}Te_{z},
**caractérisé en ce que** x = 48 % at, y = 20 % at et z = 32 % at.
